# EUROPÄISCHE PATENTSCHRIFT

(11) **EP 2 672 797 B1**
(45) Veröffentlichungstag und Bekanntmachung des Hinweises auf die Patenterteilung: **14.11.2018**
(21) Anmeldenummer: 13166815.4
(22) Anmeldetag: 07.05.2013
(51) Int. Cl.: H05K 7/20, H05K 5/02, F25B 21/02

(54) **Schaltschrank mit Batterieraum**
Control cabinet with battery compartment
Armoire électrique avec compartiment pour batteries

(30) Priorität: 06.06.2012 DE 102012011203
(43) Veröffentlichungstag der Anmeldung: 11.12.2013
(73) Patentinhaber: Rittal GmbH & Co. KG, 35745 Herborn (DE)
(72) Erfinder: Deusing, Markus, 35688 Dillenburg (DE); Hartmann, Dietmar, 57076 Siegen (DE); Malzacher, Dietrich, 35744 Hohenahr (DE)
(74) Vertreter: Angerhausen, Christoph

(56) Entgegenhaltungen:
- WO-A1-2010/085691
- US-A- 4 495 780
- US-A1- 2007 144 704
- US-A1- 2010 059 270
- US-B1- 6 294 721

## Beschreibung

Die Erfindung betrifft einen Schaltschrank, mit einem ersten Raum zur Aufnahme elektronischer Bauteile und mit einem zweiten Raum zur Aufnahme von Batterien oder anderen temperaturempfindlichen Bauteilen, wobei der erste und der zweite Raum durch eine Zwischenwand voneinander abgetrennt sind und in dem zweiten Raum aufgenommene Luft von einem thermoelektrischen Kühlelement gekühlt ist, und wobei der erste Raum einen Lüfter aufweist, so dass Umgebungsluft durch einen Lufteinlass in den ersten Raum hinein und erwärmte Luft durch einen Luftauslass aus dem ersten Raum heraustransportiert ist, und wobei Abwärme des thermoelektrischen Kühlelements an die den ersten Raum durchströmende Luft abgeleitet ist. Ein derartiger Schaltschrank ist aus der US 6,294,721 B1 bekannt. Ähnliche Anordnungen zeigen auch die DE 295 09 930 U1, die US 2010/0059270 A1, die US 4,495,780 A, die US 2007/0144704 A1 und die WO 2010/085691 A1.

Gattungsgemäße Schaltschränke zeichnen sich dadurch aus, dass sie elektrische Speicher, wie Batterien aufweisen, welche zur Optimierung ihrer Speicherkapazität sowie Leistungsabgabe unter Einhaltung eines engen Temperaturfensters von ungefähr 20°C - 25°C gelagert werden müssen. Die in dem ersten Raum des Schaltschrankes im Übrigen aufgenommenen elektronischen Bauteile verhalten sich in der Regel jedoch wesentlich unkritischer in Bezug auf ihre Umgebungstemperatur. Je nach Aufstellungsort des Schaltschrankes und je nach Bauart der in dem ersten Raum aufgenommenen elektronischen Bauteile kann die Temperatur in dem ersten Raum beispielsweise zwischen 5 °C und 55°C liegen, ohne dass dabei die elektronischen Bauteile in dem ersten Raum Schaden nehmen oder ihre Leistungsfähigkeit beeinträchtigt wird.

Aus dem Stand der Technik ist es daher bekannt, neben dem für die Temperierung der in dem ersten Raum aufgenommenen Luft vorgesehenen Kühlkreislauf einen zweiten Kühlkreislauf vorzusehen, welcher entweder ein eigenständiger Kühlkreislauf oder ein von dem ersten Kühlkreislauf abgezweigter Kühlkreislauf ist, der unabhängig von dem ersten Kühlkreislauf zur Kühlung der in dem zweiten Raum aufgenommenen temperaturempfindlichen Bauteile zur Einhaltung des engen Temperaturbereiches geregelt wird. Aufgrund des Umstandes, dass die beiden Kühlkreisläufe auf Verdampferseite auf einem unterschiedlichen Temperaturniveau arbeiten, ist die Energiebilanz des Gesamtkühlsystems unvorteilhaft, was daran liegt, dass sich die Kompressorleistung und damit die Vorlauftemperatur der Verdampfer nach der niedrigeren der beiden Zieltemperaturen von erstem und zweitem Raum richten muss.

Es ist daher die Aufgabe der Erfindung, einen gattungsgemäßen Schaltschrank vorzuschlagen, der eine energieoptimierte Kühlung sowohl des ersten als auch des zweiten Raumes ermöglicht.

Diese Aufgabe wird erfindungsgemäß von einem Schaltschrank mit den Merkmalen des Patentanspruchs 1 gelöst. Die abhängigen Ansprüche betreffen jeweils vorteilhafte Ausführungsformen der Erfindung.

Der erfindungsgemäße Schaltschrank ist dadurch gekennzeichnet, dass der Schaltschrank ein Rahmengestell aufweist und die Zwischenwand an ihren Ecken an einem jeweiligen Vertikalprofil des Rahmengestells befestigt ist und entlang ihrer Berandung an einem Wandelement des Schaltschrankes mittelbar über ein Dichtelement anliegt.

Die Erfindung macht sich die Erkenntnis zu Nutze, dass für die in dem ersten Raum aufgenommenen Komponenten in der Regel eine Kühlung ausschließlich über das Durchleiten von Umgebungsluft durch den ersten Raum erfolgen kann, so dass es je nach Ausführungsform erfindungsgemäß hinreichend ist, dass der erste Raum einen Lufteinlass und einen Luftauslass aufweist, wobei ein in dem ersten Raum vorgesehener Lüfter oder eine ähnliche Lufttransporteinheit die Umgebungsluft über die Lufteinlassseite ansaugt, durch den ersten Raum transportiert und an der Luftauslassseite ausbläst. Der Erfindung liegt die weitere Erkenntnis zugrunde, dass die von den Energiespeichern, beispielsweise Batterien, ausgehende Verlustleistung so gering ist, dass es zur energieoptimierten Kühlung dieser hinreichend ist, in dem zweiten Raum zur Kühlung der von diesem aufgenommenen Luft ein thermoelektrisches Kühlelement vorzusehen. Erfindungsgemäß beschränkt sich die Energieaufnahme des Gesamtsystems somit auf die Energieaufnahme des thermoelektrischen Elementes sowie die Energieaufnahme des Lüfters in dem ersten Raum, wobei letzterer insbesondere ein Radiallüfter mit niedriger Leistungsaufnahme sein kann.

Dadurch, dass die Abwärme des thermoelektrischen Kühlelements an die den ersten Raum durchströmende Luft abgeleitet wird, kann die Wärme somit mit Hilfe des in dem zweiten Raum vorgesehenen Lüfters aus dem Schaltschrankinnern transportiert werden.

Bei einer Ausführungsform der Erfindung ist vorgesehen, dass das thermoelektrische Element eine warme Seite und eine kühlende Seite aufweist, wobei das thermoelektrische Element derart von der Zwischenwand aufgenommen ist, dass die kühlende Seite mit der in dem zweiten Raum aufgenommenen Luft fluidisch in Verbindung steht, und dass die warme Seite mit der den ersten Raum durchströmenden Luft fluidisch in Verbindung steht. Konstruktionsbedingt bauen thermoelektrische Elemente, wie zum Beispiel Peltier-Elemente, flach und weisen parallele Flächen auf, von denen jeweils eine die warme Seite und die kühlende Seite bildet. Derartige thermoelektrische Elemente können somit derart in die Zwischenwand eingelassen werden, dass sich die warme Seite und die kühlende Seite jeweils parallel zu der Zwischenwand erstrecken, wobei eine der beiden Seiten in den ersten Raum und die andere Seite in den zweiten Raum hineinragt. Thermoelektrische Elemente haben häufig die Eigenschaft, dass sich bei Umkehrung der Polung der angelegten elektrischen Spannung auch die warme Seite und die kühlende Seite gegeneinander umkehren. Bei der besonders bevorzugten Ausführungsform ist vorgesehen, dass die Zwischenwand eine dem ersten Raum zugewandte Seite und eine dem zweiten Raum zugewandte Seite aufweist, wobei die Zwischenwand einen Ausschnitt aufweist, der einen Durchlass zwischen diesen beiden Seiten bildet, und wobei das thermoelektrische Element in den Ausschnitt eingesetzt ist, derart, dass die Zwischenwand eine dem ersten Raum zugewandte warme Seite des thermoelektrischen Elements von einer dem zweiten Raum zugewandten kühlenden Seite des thermoelektrischen Elementes fluidisch abtrennt.

Um eine weitere Effizienzsteigerung des Gesamtsystems zu erreichen, ist bei einer Ausführungsform der Erfindung vorgesehen, dass der zweite Raum eine Wärmedämmung aufweist, so dass der Wärmedurchgangskoeffizient zwischen dem Innern des zweiten Raumes und der Umgebung des zweiten Raums vorzugsweise kleiner als 2 ist.

Um eine besonders einfache Integration des erfindungsgemäßen Kühlkonzepts in gattungsgemäßen Schaltschränken zu ermöglichen, ist vorgesehen, dass der Schaltschrank ein Rahmengestell aufweist, wobei die Zwischenwand an ihren Ecken an dem Rahmengestell befestigt ist, und wobei die Zwischenwand entlang ihrer Berandung an Wandelementen des Schaltschrankes mittelbar über ein Dichtelement anliegt.

Um den Wirkungsgrad des thermoelektrischen Elementes weiter zu steigern, ist bei einer Ausführungsform der Erfindung vorgesehen, dass dem thermoelektrischen Element entweder an der dem ersten Raum zugewandten kühlenden oder warmen Seite, oder an der dem zweiten Raum zugewandten kühlenden oder warmen Seite, oder an beiden Seiten, eine Lüftereinheit zugewiesen ist, so dass die jeweilige Luft des ersten bzw. des zweiten Raumes entlang der jeweiligen kühlenden oder warmen Seite zwecks Wärmeaustausch mit der jeweiligen Seite transportiert werden kann.

Je nach Aufstellungsort und Temperaturempfindlichkeit der in dem ersten Raum aufgenommenen elektronischen Bauteile kann es vorkommen, dass die über die Durchleitung der Umgebungsluft durch den ersten Raum erzielbare Kühlleistung nicht ausreicht. In diesem Fall sieht eine Ausführungsform der Erfindung vor, dass in dem Luftströmungsweg, welcher zwischen dem Lufteinlass und dem Luftauslass ausgebildet ist, ein Wärmetauscher, vorzugsweise ein Luft-Wasser-Wärmetauscher, angeordnet ist. Der Luft-Wasser-Wärmetauscher kann Bestandteil eines kompressorgetriebenen Kältekreislaufs sein. Er kann ebenso Bestandteil eines Freecooling-Kreislaufes sein.

Weitere Einzelheiten der Erfindung werden anhand der nachstehenden Figuren erläutert. Dabei zeigt:
- Figur 1: einen Vertikalquerschnitt einer Ausführungsform der Erfindung;
- Figur 2: eine Draufsicht auf die Türseite des Schaltschranks gemäß Figur 1; und
- Figur 3: eine perspektivische Ansicht von schräg unten auf die Ausführungsform gemäß den Figuren 1 und 2.

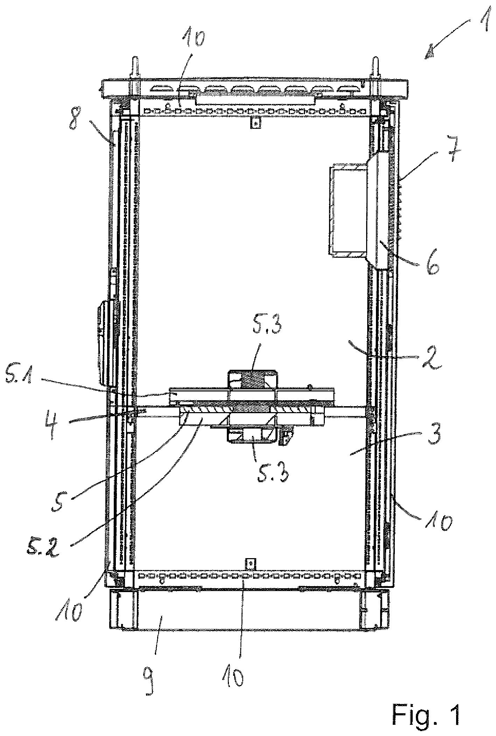

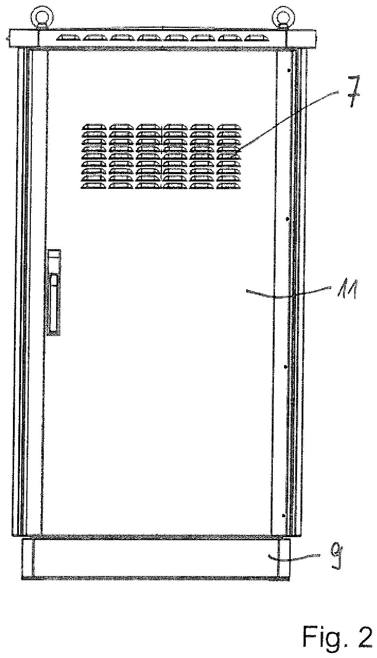

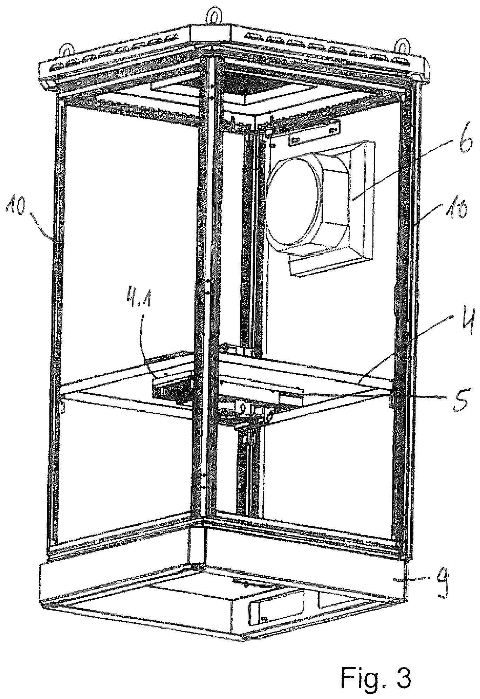

Die Figuren 1 bis 3 zeigen eine Ausführungsform der Erfindung, bei der der Schaltschrank 1 ein Rahmengestell 10, bestehend aus Vertikalprofilen und Horizontalprofilen, aufweist, wobei an dem Rahmengestell 10 Wandelement 11 befestigt sind. Das in Figur 2 sichtbare Wandelement 11 ist ein Türelement, an dessen Vorderseite die Lufteinlassseite 7 ausgebildet ist. Das Rahmengestell 10 ist auf einem Sockel 9 abgestützt. Wie den Figuren 1 und 3 zu entnehmen ist, ist der von dem Rahmengestell 10 und den Wandelementen 11 abgegrenzte Innenraum des Schaltschrankes 1 über eine horizontale Zwischenwand 4 in einen ersten Raum 2 und einen zweiten Raum 3 unterteilt. Die Zwischenwand 4 ist an ihren Eckpunkten an einem jeweiligen Vertikalprofil des Rahmengestells 10 befestigt. Die Zwischenwand 4 weist an ihrer Umrandung eine Abkantung auf, so dass eine Dichtfläche zu dem jeweiligen Wandelement 11, an welchem die Zwischenwand 4 entlang ihrer Umrandung anliegt, ausgebildet wird. Auf diese Weise wird erreicht, dass der Übergang zwischen der Zwischenwand 4 und dem jeweils angrenzenden Wandelement 11 im Wesentlichen fluidisch dicht ist. Die Zwischenwand 4 weist einen zentralen Ausschnitt 4.1 auf, welcher einen Durchlass zwischen der dem ersten Raum 2 zugewandten Seite der Zwischenwand 4 und der dem zweiten Raum 3 zugewandten Seite der Zwischenwand 4 ausbildet. In diesem Durchlass ist das thermoelektrische Element 5 derart eingesetzt, dass die warme Seite 5.1 des thermoelektrischen Elements 5 in dem ersten Raum 2 und die kühlende Seite 5.2 des thermoelektrischen Elements 5 in dem zweiten Raum 3 liegt. Das thermoelektrische Element 5 dient damit als Wärmepumpe zwischen dem ersten Raum 2 und dem zweiten Raum 3. Lüfter 5.3 dienen dazu, die in dem ersten Raum 2 bzw. die in dem zweiten Raum 3 aufgenommene Luft für den Wärmeaustausch an der warmen Seite 5.1 bzw. an der kühlenden Seite 5.2 vorbeizuleiten. Der erste Raum 2 weist neben dem Lufteinlass 7 einen Luftauslass 8 auf, wobei mittels des Lüfters 6 über den Lufteinlass 7 Umgebungsluft angesogen, durch den ersten Raum 2 hindurch transportiert und über den Luftauslass 8 aus dem zweiten Raum 2 ausgetrieben wird. Während die über den Lufteinlass 7 angesogene Umgebungsluft durch den ersten Raum 2 strömt, kann von den in dem ersten Raum 2 aufgenommenen elektronischen Komponenten erzeugte Verlustwärme an die Umgebungsluft abgetauscht werden. Neben der Verlustleistung der in dem ersten Raum 2 aufgenommenen elektronischen Bauteile wird an die durch den ersten Raum 2 geleitete Luft auch die mittels dem thermoelektrischen Kühlelement 5 aus dem zweiten Raum 3 herausgeförderte Wärme an die Luft in dem ersten Raum 2 abgetauscht. Dies hat den Vorteil, dass der zweite Raum 3 als im Wesentlichen fluidisch dichter Raum ausgebildet sein kann.

### Bezugszeichenliste

- 1: Schaltschrank
- 2: erster Raum
- 3: zweiter Raum
- 4: Zwischenwand
- 4.1: Ausschnitt
- 5: thermoelektrisches Element
- 5.1: warme Seite
- 5.2: kühlende Seite
- 5.3: Lüftereinheit
- 5: Lüfter
- 7: Lufteinlass
- 8: Luftauslass
- 9: Sockel
- 10: Rahmengestell
- 11: Wandelement

## Patentansprüche

1. Schaltschrank (1), der in seinem Innern einen ersten Raum (2) zur Aufnahme elektronischer Bauteile und einen zweiten Raum (3) zur Aufnahme von Batterien oder anderen temperaturempfindlichen Bauteilen aufweist, wobei der erste und der zweite Raum (2, 3) durch eine Zwischenwand (4) voneinander getrennt sind und in dem zweiten Raum (3) aufgenommene Luft von einem thermoelektrischen Kühlelement (5) gekühlt ist, wobei der erste Raum (2) einen Lüfter (6) aufweist, so dass Umgebungsluft durch einen Lufteinlass (7) in den ersten Raum (2) hinein und erwärmte Luft durch einen Luftauslass (8) aus dem ersten Raum (2) heraustransportiert ist, und wobei Abwärme des thermoelektrischen Kühlelements (5) an die den ersten Raum (2) durchströmende Luft abgeleitet ist, **dadurch gekennzeichnet, dass** der Schaltschrank ein Rahmengestell (10) aufweist und die Zwischenwand (4) an ihren Ecken an einem jeweiligen Vertikalprofil des Rahmengestells (10) befestigt ist und entlang ihrer Berandung an einem Wandelement (11) des Schaltschrankes (10) mittelbar über ein Dichtelement anliegt.

2. Schaltschrank (1) nach Anspruch 1, bei dem das thermoelektrische Element (5) eine warme Seite (5.1) und eine kühlende Seite (5.2) aufweist, und bei dem das thermoelektrische Element (5) derart von der Zwischenwand (4) aufgenommen ist, dass die kühlende Seite (5.2) mit der in dem zweiten Raum (3) aufgenommenen Luft fluidisch in Verbindung steht, und dass die warme Seite (5.1) mit der den ersten Raum (2) durchströmenden Luft fluidisch in Verbindung steht.

3. Schaltschrank (1) nach einem der vorangegangenen Ansprüche, bei dem der zweite Raum (3) eine Wärmedämmung aufweist, so dass der Wärmedurchgangskoeffizient k zwischen dem Innern des zweiten Raums (3) und der Umgebung des zweiten Raums (3) kleiner als 2 ist.

4. Schaltschrank (1) nach einem der vorangegangenen Ansprüche, bei dem die Zwischenwand (4) eine dem ersten Raum (2) zugewandte Seite und eine dem zweiten Raum (3) zugewandte Seite aufweist, wobei die Zwischenwand (4) einen Ausschnitt (4.1) aufweist, der einen Durchlass zwischen diesen beiden Seiten bildet, und wobei das thermoelektrische Element (5) in den Ausschnitt (4.1) eingesetzt ist, derart, dass die Zwischenwand (4) eine dem ersten Raum (2) zugewandte warme Seite des thermoelektrischen Elements (5) von einer dem zweiten Raum (3) zugewandten kühlenden Seite des thermoelektrischen Elements (5) fluidisch abtrennt.

5. Schaltschrank (1) nach Anspruch 4, bei dem das thermoelektrische Element (5) entweder an der dem ersten Raum 2 zuwandten warmen Seite, oder an der dem zweiten Raum (3) zugewandten kühlenden Seite, oder an beiden Seiten, eine Lüftereinheit (5.3) aufweist, so dass die jeweilige Luft des ersten bzw. des zweiten Raumes (2, 3) entlang der jeweiligen kühlenden oder warmen Seite transportiert ist.

6. Schaltschrank (1) nach einem der vorangegangenen Ansprüche, bei dem in einem Luftströmungsweg zwischen dem Lufteinlass (7) und dem Luftauslass (8) ein Wärmetauscher, vorzugsweise ein Luft-Wasser-Wärmetauscher, angeordnet ist.

## Claims

1. Switch cabinet (1), comprising in its interior a first chamber (2) for mounting electrical components and a second chamber (3) for mounting batteries or other temperature-sensitive components, the first and second chamber (2, 3) being separated by a partition wall (4) and the air inside the second chamber being cooled by a thermoelectric cooling element (5), the first chamber (2) comprising a fan (6), so that ambient air is transported into the first chamber (2) via an air inlet (7) and warm air is transported out of the first chamber (2) via an air outlet (8) and wherein waste heat of the thermoelectric cooling element (5) is transferred to the air flowing though the first chamber (2), **characterized in that** the switch cabinet comprises a frame and the separation wall (4) is fixed at its corners at a respective vertical profile of the frame (10) and abuts along its edge a wall element (11) of the switch cabinet (10) indirectly via a sealing element.

2. Switch cabinet (1) according to claim 1, wherein the thermoelectric element has a warm side (5.1) and a cooling side (5.2), and wherein the thermoelectric element is supported by the partition wall (4) such that the cooling side (5.2) is fluidically connected with the air inside the second chamber (3), and such that the warm side (5.1) is fluidically connected to the air flowing through the first chamber (2).

3. Switch cabinet (1) according to one of the preceding claims, wherein the second chamber (3) comprises a thermal insulation, so that the heat transfer coefficient k between the interior of the second chamber (3) and the surroundings of the second chamber (3) is smaller than 2.

4. Switch cabinet (1) according to one of the preceding claims, wherein the partition wall (4) has a side facing the first chamber (2) and a second side facing the second chamber (3), wherein the partition wall (4) comprises a cutout (4.1), which forms an opening between these two sides, and wherein the thermoelectric element (5) is inserted into the cutout (4.1), such that the partition wall (4) fluidically separates a cooling or warm side of the thermoelectric element (5) facing the first chamber (2) from a cooling or warm side of the thermoelectrical element (5) facing the second chamber (3).

5. Switch cabinet (1) according to claim 4, wherein the thermoelectric element (5) comprises a fan unit (5.3) either on the cooling or warm side facing the first chamber (2), or on the cooling or warm side facing the second chamber (3), or on both sides, so that the respective air of the first or second room (2, 3) is transported along the respective cooling or warm side.

6. Switch cabinet (1) according to one of the preceding claims, wherein a heat exchanger, preferably an air-water-heat exchanger, is arranged in an air flow path between the air inlet (7) and the air outlet (8).

## Revendications

1. Armoire de commande (1) qui comprend, à l'intérieur, une première chambre (2) pour le logement de composants électroniques et une deuxième chambre (3) pour le logement de batteries ou d'autres composants sensibles à la température, la première et la deuxième chambres (2, 3) étant séparées par une cloison (4) et l'air logé dans la deuxième chambre (3) étant refroidi par un élément de refroidissement thermo-électrique (5), la première chambre (2) comprenant un ventilateur (6), de façon à ce que l'air ambiant soit transporté à travers une entrée d'air (7) vers la première chambre (2) et à ce que l'air chauffé soit transporté à travers une sortie d'air (8) hors de la première chambre (2) et la chaleur dégagée par l'élément de refroidissement thermo-électrique (5) étant déviée vers l'air traversant la première chambre (2), **caractérisée en ce que** l'armoire de commande comprend un châssis (10) et la cloison (4) est fixée, au niveau de ses angles, à un profilé vertical correspondant du châssis (10) et s'appuie, le long de son bord, contre un élément de paroi (11) de l'armoire de commande (10) indirectement par l'intermédiaire d'un élément d'étanchéité.

2. Armoire de commande (1) selon la revendication 1, dans laquelle l'élément thermo-électrique (5) comprend un côté chaud (5.1) et un côté de refroidissement (5.2) et dans lequel l'élément thermo-électrique (5) est logé par la cloison (4) de façon à ce que le côté de refroidissement (5.2) est relié avec l'air logé dans la deuxième chambre (3), et le côté chaud (5.1) est relié de manière fluidique avec l'air traversant la première chambre (2).

3. Armoire de commande (1) selon l'une des revendications précédentes, dans laquelle la deuxième chambre (3) comprend une isolation thermique, de façon à ce que le coefficient de transfert thermique k entre l'intérieur de la deuxième chambre (3) et l'environnement de la deuxième chambre (3) est inférieur à 2.

4. Armoire de commande (1) selon l'une des revendications précédentes, dans laquelle la cloison (4) comprend un côté orienté vers la première chambre (2) et un côté orienté vers la deuxième chambre (3), la cloison (4) comprenant une découpe (4.1), qui forme un passage entre ces deux côtés, et l'élément thermo-électrique (5) étant inséré dans la découpe (4.1), de façon à ce que la cloison (4) sépare de manière fluidique un côté chaud orienté vers la première chambre (2) de l'élément thermo-électrique (5) d'un côté de refroidissement orienté vers la deuxième chambre (3) de l'élément thermo-électrique (5).

5. Armoire de commande (1) selon la revendication 4, dans laquelle l'élément thermo-électrique (5) comprend, soit sur le côté chaud orienté vers la première chambre (2), soit sur le côté de refroidissement orienté vers la deuxième chambre (3) soit sur les deux côtés, une unité de ventilateur (5.3), de façon à ce que l'air de la première ou de la deuxième chambre (2, 3) soit transporté le long du côté de refroidissement ou du côté chaud.

6. Armoire de commande (1) selon l'une des revendications précédentes, dans laquelle, dans un trajet d'écoulement d'air entre l'entrée d'air (7) et la sortie d'air (8), est disposé un échangeur thermique, de préférence un échangeur thermique air-eau.
